# EUROPEAN PATENT APPLICATION

(11) **EP 2 423 347 A1**
(43) Date of publication of application: **29.02.2012**
(21) Application number: 10174520.6
(22) Date of filing: 30.08.2010
(51) Int. Cl.: C23C 4/12, C23C 14/00, C23C 14/08, C23C 14/30, C23C 28/00, C23C 30/00, F01D 5/28, F01D 25/00

(54) **Method for forming a thermal barrier coating and a turbine component with the thermal barrier coating**

(71) Applicant: SIEMENS AKTIENGESELLSCHAFT, 80333 München (DE)
(72) Inventor: Lampenscherf, Stefan, 85586 Poing (DE); Casu, Alessandro, 47057 Duisburg (DE); Kulkarni, Anand A., Oviedo, FL 32766 (US)

(57) **Abstract**

A method for forming a thermal barrier coating (90) is provided. The method includes applying a bond coat layer (96) over a surface (94) of a substrate (92), applying an insulating layer (97) over the bond coat layer (96), the insulating layer (97) includes a first ceramic material and a second ceramic material, wherein the first ceramic material has a higher temperature capability than the second ceramic material, characterized in that the insulating layer (97) has a decreasing proportion of the second ceramic material to the first ceramic material along a thickness of the insulating layer (97).

## Description

The present invention relates to a method for forming a thermal barrier coating and a turbine component with such a coating.

Thermal Barrier Coating (TBC) have been readily employed on first and second rows of turbine blades and vanes as well as on combustor chamber components exposed to the hot gas path of industrial gas turbines (IGT). Typically, yttria stabilized zirconia TBCs are extensively applied to the hot sections and provide protection against thermo-mechanical shock, high temperature oxidation and hot corrosion degradation. While the primary driver to implement TBCs has been initially the life time extension of the coated components, advanced IGTs utilize TBCs more and more to allow for increases in efficiency and power output of a gas turbine. One measure to improve efficiency and power output is to reduce the cooling air consumption of the components in the hot gas path, that is, by allowing those components to be operated at higher temperatures. The push to higher firing temperatures and reduced cooling flows generates an on-going demand for advanced TBCs with higher temperature stability and better thermal insulation to achieve long term efficiency and performance goals of advanced industrial gas turbines.

The TBC comprises a two-layer system with an outer insulating ceramic layer and an underlying oxidation-resistant metallic layer or a bond coat layer deposited directly onto the surface of the metallic component. The bond coat provides the physical and chemical bond between the ceramic coating and the substrate and serves as an oxidation and corrosion resistance by forming a slow growing adherent protective Alumina scale. The top ceramic layer provides benefits in performance, efficiency and durability through a) increased engine operating temperature; b) extended metallic component lifetime when subjected to elevated temperature and stress; and c) reduced cooling requirements for the metallic components. Depending on the ceramic layer thickness and through thickness heat flux, substrate temperatures can be reduced by several hundred degrees. The development and acceptance of TBCs are closely linked to processing technology. In this connection, ceramic topcoats are presently deposited using air plasma spray (APS) or electron beam-physical vapor deposition (EB-PVD) processes. Although both coatings have the same chemical composition, their microstructures are fundamentally different from each other and so are their thermal insulation properties and performance.

Currently, double or multi layered TBC coatings are used with a bond coat compatible TBC sub-layer, which is generally a yttria stabilized zirconia (YSZ) provide chemical and mechanical compatibility with the bond coat and with one or more high temperature stable TBC top layers improving temperature stability.

However, with increase in operating temperatures, the life limiting TBC failure mechanism changes from oxidation driven delamination at the interface between the TBC and bond coat to sinter driven defect originating the surface of the TBC. These surface defects cause vertical fissures and eventually TBC delaminations resulting in failure of the TBC by originating from the vertical fissures and once they reach the interface for example between the TBC and bond coat layer, the fissures grow along these interfaces causing functional failure and loss of structural integrity of the TBC.

A known way to prevent this failure mechanism is segmentation of the TBC and increasing roughness of the interfaces. However, these methods do not provide substantial resistance to the failure mechanism due to a substantial difference in fracture toughness of the materials in the TBC, wherein YSZ has higher fracture toughness than a low thermal conductivity top layer of the TBC.

It is therefore an object of the present invention to provide a thermal barrier coating and a turbine component with the coating having higher temperature stability and fracture resistance with respect to the delamination crack.

The object is achieved by providing a method for forming a thermal barrier coating according to claim 1 and providing a turbine component with coating according to claim 7.

The present invention suggests improving high temperature stability of a thermal barrier coating and providing fracture resistance with respect to the delamination crack by using an insulating layer over a bond coat layer, the insulating layer comprises a first ceramic material and a second ceramic material, wherein the first ceramic material has a higher temperature capability than the second ceramic material. The insulating layer has a decreasing proportion of the second ceramic material to the first ceramic material along a thickness of the insulating layer. By having a decreasing proportion of the second ceramic material to the first ceramic material along the thickness of the insulating layer, a gradient interface between the second ceramic material and the first ceramic material is achieved in the insulating layer which advantageously reduces a tendency of vertical-to-horizontal crack deflection and increases fracture resistance with respect to delamination cracks. Also, the second ceramic material has excellent fracture resistance and bond coat compatibility compared to the first ceramic material which has a high sinter resistance. In addition, the gradient interface also improves higher temperature stability of the insulating layer thereby increasing efficiency and performance and provides a cost effective solution for industrial gas turbines.

In one embodiment, the insulating layer includes a plurality of layers having a variable proportion of the first ceramic material and the second ceramic material. The plurality of layers with variable proportion ensures achieving a gradient interface design in the insulating layer.

In another embodiment, the bond coat layer is applied using an electron beam physical vapor deposition or an air plasma spray process. This ensures a uniform deposition of the bond coat layer over a surface of a substrate.

In yet another embodiment, the insulating layer has a 100% second ceramic material immediately over the bond coat layer. The second ceramic material is compatible with the bond coat layer and provides chemical and mechanical compatibility with the bond coat ensuring stability at high temperatures.

The insulating layer has a 100% first ceramic material distal to the bond coat layer. The first ceramic material has low thermal conductivity and provides an excellent thermal insulation because of high temperature capability.

The second ceramic material comprises yttria stabilized zirconia which provides adherence to bond coat.

The first ceramic material comprises pyrochlores, perovskites, tungsten bronze or magnetoplumbite structures. These materials have low thermal conductivity and provide excellent thermal insulation.

The above-mentioned and other features of the invention will now be addressed with reference to the accompanying drawings of the present invention. The illustrated embodiments are intended to illustrate, but not limit the invention. The drawings contain the following figures, in which like numbers refer to like parts, throughout the description and drawings.
FIG. 1 is a schematic diagram of a gas turbine;
FIG. 2 is a schematic diagram of a turbine blade;
FIG. 3 is a schematic diagram of a combustion chamber; and
FIG. 4 is a partial cross-sectional view of a turbine component coated with an exemplary thermal barrier coating.

Embodiments of the present invention relate to thermal barrier coating and more particularly to a turbine component coated with the thermal barrier coating. As previously noted, thermal barrier coatings are employed to protect turbine components, such as a blade, a vane or combustor components that are exposed to a hot gas path.

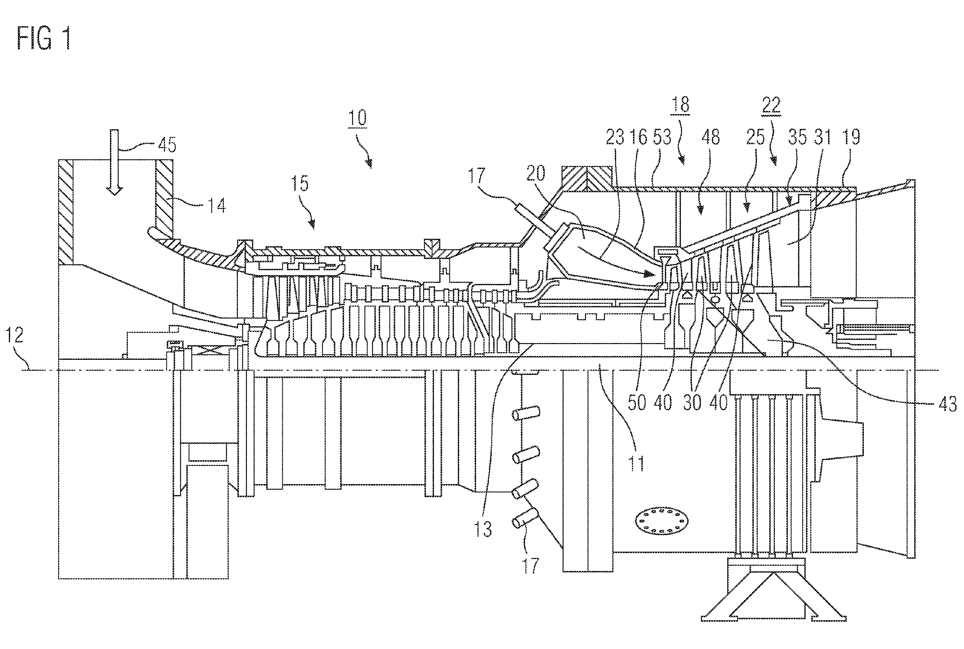

FIG. 1 is a schematic diagram of a gas turbine 10 depicting internal components. The gas turbine 10 includes a rotor 13 which is mounted such that it can rotate along an axis of rotation 12, has a shaft 11 and is also referred to as a turbine rotor.

The gas turbine 10 includes an intake housing 14, a compressor 15, an annular combustion chamber 20 with a plurality of coaxially arranged burners 17; a turbine 18 and exhaust-gas housing 19 follow one another along the rotor 13.

The annular combustion chamber 20 is in communication with an annular hot-gas passage 21, where, by way of example, four successive turbine stages 22 form the turbine 18.

It may be noted that each turbine stage 22 is formed, for example, from two blade or vane rings. As seen in the direction of flow of a working medium 23, in the hot gas passage 21 a row of guide vanes 25 is followed by a row 35 formed from rotor blades 30. The guide vanes 40 are secured to an inner housing 48 of a stator 53, whereas the rotor blades 30 of the row 35 are fitted to the rotor 13 for example by means of a turbine disk 43.

A generator not shown in FIG. 1 is coupled to the rotor 13. During the operation of the gas turbine 10, the compressor 15 sucks in air 45 through the intake housing 14 and compresses it. The compressed air provided at the turbine-side end of the compressor 15 is passed to the burners 17, where it is mixed with a fuel. The mix is then burnt in the combustion chamber 20, forming the working medium 23. From there, the working medium 23 flows along the hot-gas passage 21 past the guide vanes 40 and the rotor blades 30. The working medium 23 is expanded at the rotor blades 30, transferring its momentum, so that the rotor blades 30 drive the rotor 13 and the latter in turn drives the generator coupled to it.

In addition, while the gas turbine 10 is in operation, the components which are exposed to the hot working medium 23 are subjected to thermal stresses. The guide vanes 40 and the rotor blades 30 of the first turbine stage 22, as seen in the direction of flow of the working medium 23, together with the heat shield bricks which line the annular combustion chamber 20, are subject to the highest thermal stresses. These components are typically cooled by a coolant, such as oil.

As will be appreciated, the components of the gas turbine 10 are made from a material such as superalloys which are iron-based, nickel-based or cobalt-based. More particularly, the turbine vane or blade 40, 30 and components of the combustion chamber 20 are made from the superalloys mentioned hereinabove.

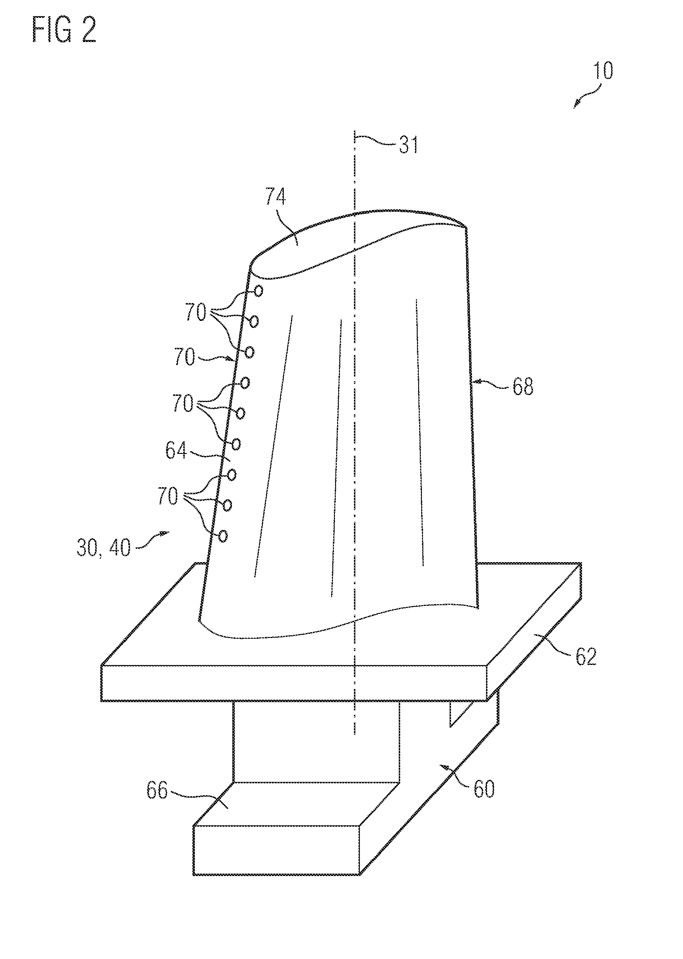

FIG. 2 is a schematic diagram depicting a perspective view of a rotor blade 30 or a guide vane 40 of a turbomachine, which extends along a longitudinal axis 31. The blade or vane 30, 40 has, in succession along the longitudinal axis 31, a securing region 60, an adjoining blade or vane platform 62 and a main blade or vane part 64 as well as a blade or vane tip 74.

The blade or vane 30, 40 has a blade or vane root 66 facing the inner housing 48 (see FIG. 1) of the turbine 18 (see FIG. 1) and a blade or vane head at the opposite end from the blade or vane root 66. The head faces the rotor 13 and is fixed to a securing ring 50 (see FIG. 1) of the stator 53 (see FIG. 1).

In accordance with aspects of the present technique, the blade or vane root 66, which is used to secure the rotor blades 30 to a shaft or disk (not shown), is formed in the securing region 60. The blade or vane root 66 is designed, for example, in hammerhead form. Other configurations, such as a fir-tree or dovetail root, are possible. The blade or vane 30, 40 has a leading edge 72 and a trailing edge 68 for a medium which flows past the main blade or vane part 64.

As previously noted, the blades or vanes 30, 40 are formed by use of solid metallic materials, in particular superalloys, which is used at all regions 60, 62, 64 of the blade or vane 30, 40.

The blade or vane 30, 40 may be formed by a casting process, by means of directional solidification, by a forging process, a milling process or combinations thereof.

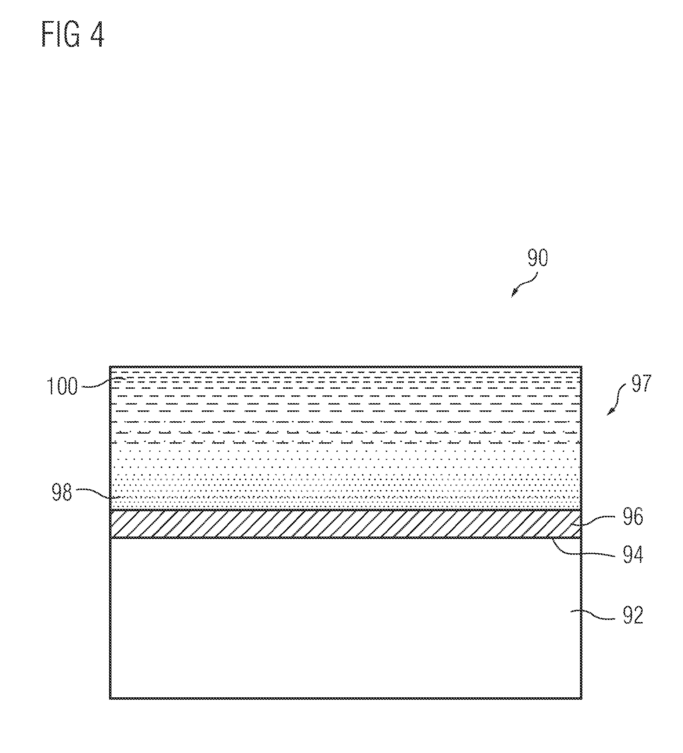

The various components of a turbomachine are exposed to thermal, mechanical and chemical stresses during the operation of the turbomachine. To protect the components a coating is generally applied on the various components to protect against corrosion or oxidation. The coating will be described in greater detail with reference to FIG. 4.

It may be noted, that the blade or vane 30, 40 also includes a plurality of film cooling holes 70 for cooling the blade or vane 30, 40.

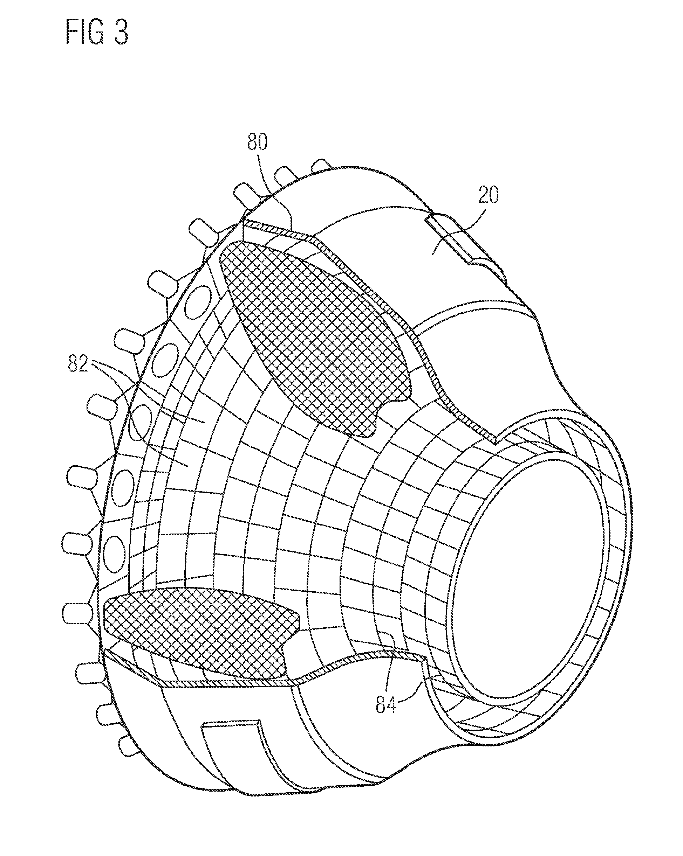

FIG. 3 is a diagrammatic illustration of a combustion chamber 20 of the gas turbine 10 of FIG. 1. The combustion chamber may also be referred to as an annular combustion chamber and includes a multiplicity of burners 17 arranged circumferentially around the axis of rotation 102 (see FIG. 1) and open out into a common combustion chamber space and generates flames. To achieve a relatively high efficiency, the combustion chamber 20 is designed for a relatively high temperature of the working medium 23 of approximately 1000 degree Celsius to 1600 degree Celsius. To allow a relatively long service life even with these operating parameters, which are unfavorable for the materials, the combustion chamber wall 80 is provided, on its side which faces the working medium 23, with an inner lining formed from heat shield elements 82.

A cooling system may also be provided for the heat shield elements 82 and/or their holding elements, on account of the high temperatures in the interior of the combustion chamber 20. The heat shield elements 82 are then, for example, hollow and if appropriate also have cooling holes (not shown) opening out into the combustion chamber space.

In addition, the combustion chamber 20 is coated with exemplary coating as will be described with reference to FIG. 4 hereinafter.

FIG. 4 shows a partial cross-sectional view of a turbine component coated with an exemplary thermal barrier coating 90, in accordance with aspects of the present technique. Components of a turbomachine, such as a gas turbine 10 of FIG. 1 are coated with the thermal barrier coating 90.

As previously noted, the components of the turbomachine such a the blade or vane 30,40 as described with reference to FIG. 2 and the combustion chamber 20 as described with reference to FIG. 3 are coated with the thermal barrier coating 90.

The components of the turbomachine include a substrate 92 having a surface 94 which is exposed to a high temperature environment. The thermal barrier coating 90 is deposited over the surface 94 of the substrate 92. The substrate 92 is a metallic substrate made up of the superalloy as mentioned with reference to FIG. 1.

More particularly, a bond coat layer 96 is applied over the surface 94 of the substrate 92. In accordance with aspects of the present technique, a metallic bond coat layer such as for example, formed from MCrAlX alloy is applied over the surface 94 of the substrate 92, wherein M is at least one element selected from the group consisting of iron (Fe), cobalt (Co), nickel (Ni), X is an active element and may include yttrium(Y) and/or silicon (Si) and/or at least one of the rare earth elements or hafnium (Hf).

The bond coat layer 96 may be applied over the surface 94 of the substrate 92 using high velocity oxy-fuel (HVOF) process, low pressure plasma spray process, atmospheric plasma spray process, air plasma spray process or an electron beam physical vapor deposition process. The HVOF process typically uses oxygen and hydrogen as fuel gases to provide coatings of highest quality. A powder material is injected through a flame having a temperature of about 2700 degree Celsius and molten particles are projected at velocities approaching 550 meters per second onto the surface. The stream of hot gas and powder is directed towards the surface to be coated. The powder partially melts in the stream, and deposits upon the substrate. The resulting coating has low porosity and high bond strength.

In plasma spray process, the material to be deposited is typically a powder, sometimes a liquid, suspension or wire is introduced into a plasma jet, emanating from a plasma torch. In the jet, where the temperature is of the order of about 10,000 Kelvin, the material is melted and propelled towards the substrate. There, the molten droplets flatten, rapidly solidify and form a deposit. Commonly, the deposits remain adherent to the substrate as coatings; free-standing parts can also be produced by removing the substrate. The air plasma spray process is performed in ambient air. In Low pressure plasma spray process the pressure is less than 6 kPa and the high pressure plasma spray process is performed at a pressure from about 6.7 to about 80 kPa (50 to 600 Torr).

In an electron beam physical vapor deposition (EB-PVD) process a target anode is bombarded with an electron beam given off by a charged tungsten filament under high vacuum. The electron beam causes atoms from the target to transform into the gaseous phase. These atoms then precipitate into solid form, coating everything in the vacuum chamber with a thin layer of the anode material. Electron beam physical vapor deposition, however, yields a high deposition rate from 0.1 µm/min to 100 µm/min at relatively low substrate temperatures, with very high material utilization efficiency.

An insulating layer 97 is applied over the bond coat layer 96. More particularly, the bond coat layer 96 is present between the surface 94 of the substrate 92 and the insulating layer 97. The insulating layer 97 includes a first ceramic material and a second ceramic material, wherein the first ceramic material has a higher temperature capability than the second ceramic material.

In another embodiment, the first ceramic material may have a lower thermal conductivity than the second ceramic material for a given density.

The first ceramic material may include pyrochlores, pervoskites, tungsten bronze or magneto-plumbite structures, such as gadolinium hafnate (Gd₂Hf₂O₇), gadolinium zirconate (Gd₂Zr₂O₇), barium neodymium titanate and so forth which typically have a porous structure.

The second ceramic material is generally formed from partially stabilized zirconia, such as, but not limited to yttria stabilized zirconia.

In accordance with aspects of the present technique, the insulating layer 97 is deposited in a manner such that, the insulating layer 97 has a decreasing proportion of the second ceramic material to the first ceramic material along a thickness of the insulating layer 97.

The insulating layer 97 includes a plurality of layers having a variable proportion of the first ceramic material and the second ceramic material. In one embodiment, the insulating layer 97 has a top layer 100 and a bottom layer 98 formed from the first ceramic material and the second ceramic material respectively.

In accordance with aspects of the present technique, the gradient interface in the insulating layer 97 may be achieved by having the plurality of layers. As an example, a first layer having 100% amount of the second ceramic material deposited over the surface of the substrate; a second layer having 67% of the second ceramic material and 33% of the first ceramic material; a third layer having 33% of the second ceramic material and 67% of the first ceramic material; and the fourth layer having 100% of the first ceramic material.

Furthermore to achieve the gradient interface, the plurality of layers may include three layers having variable composition of the first ceramic material and the second ceramic material.

The number of layers is increased if the surface temperature to which the component is subjected is increased, however, increasing the number of layers increases material cost as well as processing cost. Therefore, the number of layers is chosen so that it provides an optimum solution between temperature capability and material cost incurred.

In another embodiment, the gradient interface in the insulating layer 97 may be achieved by mixing a powdered form of the first ceramic material and the second ceramic material and applying over the bond coat layer 96.

Alternatively, the powdered form of the first ceramic material and the second ceramic material may be kept in different powder feeders and co-deposited over the bond coat layer 96. The composition of the first ceramic material and the second ceramic material may be changed in-situ to obtain the gradient interface. The insulating layer 97 is formed by spraying the powder of both the first and the second ceramic material simultaneously according to the desired composition. This technique will help in achieving a gradient transition between the plurality of layers of the thermal barrier coating 90.

Furthermore, in accordance with aspects of the present technique, the gradient interface may also be achieved using the above mentioned process between the bond coat layer 96 and the insulating layer 97 and also between the plurality of layers, such as the top layer 100 and the bottom layer 98 in the insulating layer.

In accordance with aspects of the present technique, the thickness of the top layer 100 may be from about 125 microns to about 500 microns. The thickness of the bottom layer 98 may be from about 75 microns to about 175 microns.

As will be appreciated by those skilled in the art, the thermal barrier coating may include a first layer and a second layer, the first layer is formed from the first ceramic material and the second layer is formed from the second ceramic material, there is a sharp interface between the first layer and the second layer which causes delamination cracks in the thermal barrier coating. To obviate this deficiency, a gradient interface between the first layer and the second layer is achieved using the process as described hereinabove.

The exemplary thermal barrier coating 90 is applied on various components of the turbomachine and provides resistance to thermal stresses. In addition, the exemplary thermal barrier coating increases the resistance or fracture toughness with respect to delamination cracks.

## Claims

1. A method for forming a thermal barrier coating (90) comprising:
- applying a bond coat layer (96) over a surface (94) of a substrate (92);
- applying an insulating layer (97) over the bond coat layer (96), the insulating layer (97) comprising a first ceramic material and a second ceramic material, wherein the first ceramic material has a higher temperature capability than the second ceramic material,
**characterized in that** the insulating layer (97) has a decreasing proportion of the second ceramic material to the first ceramic material along a thickness of the insulating layer (97).

2. The method according to claim 1, **characterized in that** the insulating layer (97) comprises a plurality of layers having a variable proportion of the first ceramic material and the second ceramic material.

3. The method according to claim 1 or 2, **characterized in that** the bond coat layer (96) is applied using an electron beam physical vapor deposition or an air plasma spray process.

4. The method according to claim 1 or 2, **characterized in that** the insulating layer (97) is applied over the bond coat layer (96) using air plasma spray process.

5. The method according to any of the claims 1 to 4, **characterized in that** the insulating layer (97) is completely made of the second ceramic material at the boundary to the bond coat layer (96).

6. The method according to any of the claims 1 to 4, **characterized in that** the insulating layer (97) is completely made of the first ceramic material distal to the bond coat layer (96).

7. The method according to any of the claims 1 to 6, **characterized in that** the first ceramic material and the second ceramic material are sprayed simultaneously to form the insulating layer (97).

8. A turbine component (20, 30, 40) with a thermal barrier coating (90) comprising:
- a substrate (92) having a surface (94);
- a bond coat layer (96) disposed over the surface (94) of the substrate (92);
- an insulating layer (97) disposed over the bond coat layer, wherein the insulating layer (97) comprises a first ceramic material and a second ceramic material, wherein the first ceramic material has a higher temperature capability than the second ceramic material,
**characterized in that** the insulating layer (97) has a decreasing proportion of the second ceramic material to the first ceramic material along a thickness of the insulating layer (97).

9. The turbine component (20, 30, 40) with a thermal barrier coating according to claim 8, wherein the bond coat layer (96) is disposed between the substrate (92) and the insulating layer (97).

10. The turbine component (20, 30, 40) with a thermal barrier coating according to claim 8 or 9, wherein the insulating layer (97) comprises a plurality of layers (98, 100) having a variable proportion of the first ceramic material and the second ceramic material.

11. The turbine component (20, 30, 40) with a thermal barrier coating according to any of the claims 8 to 10, wherein the first ceramic material has a lower thermal conductivity than the second ceramic material for a given density.

12. The turbine component (20, 30, 40) with a thermal barrier coating according to any of the claims 8 to 11, wherein the bond coat layer (96) comprises an alloy MCrAlX, wherein M is a ferrous metal and X comprises one of an yttrium, silicon or a rare earth element.

13. The turbine component (20, 30, 40) with a thermal barrier coating according to any of the claims 8 to 12, wherein the first ceramic material comprises pyrochlores, perovskites, tungsten bronze or magnetoplumbite structures.

14. The turbine component (20, 30, 40) with a thermal barrier coating according to any of the claims 8 to 13, wherein the second ceramic material comprises yttria stabilized zirconia.

15. The turbine component (20, 30, 40) according any of the claims 8 to 14, wherein the thermal barrier coating is applied according to a method according to any of the claims 1 to 7.
